(19) **Europäisches Patentamt / European Patent Office / Office européen des brevets**

(11) **EP 3 039 805 B1**

(12) **FASCICULE DE BREVET EUROPEEN**

(45) Date de publication et mention de la délivrance du brevet:
**17.07.2019 Bulletin 2019/29**

(21) Numéro de dépôt: **14777577.9**

(22) Date de dépôt: **29.09.2014**

(51) Int Cl.:
*H03M 13/39* (2006.01)          *H04L 1/00* (2006.01)
*H04L 25/03* (2006.01)          *H03M 13/00* (2006.01)
*H04L 1/06* (2006.01)

(86) Numéro de dépôt international:
**PCT/EP2014/070763**

(87) Numéro de publication internationale:
**WO 2015/049194 (09.04.2015 Gazette 2015/14)**

(54) **MÉTHODE DE DÉCODAGE MAP PAR RÉSEAU DE POINTS AUGMENTÉ**

MAP DECODIERUNGSVERFAHREN UNTER VERWENDUNG EINES ERWEITERTEN LATTICE

MAP DECODING METHOD USING EXTENDED LATTICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.10.2013 FR 1359497**

(43) Date de publication de la demande:
**06.07.2016 Bulletin 2016/27**

(73) Titulaire: **Institut Mines-Telecom
75013 Paris (FR)**

(72) Inventeurs:
• **MEJRI, Asma
06600 Antibes (FR)**
• **REKAYA-BEN OTHMAN, Ghaya
F-92160 Antony (FR)**

(74) Mandataire: **Hnich-Gasri, Naïma
Marks & Clerk France
Immeuble Visium
22, avenue Aristide Briand
94117 Arcueil Cedex (FR)**

(56) Documents cités:
• **ASMA MEJRI ET AL: "Lattice decoding for the Compute-and-Forward protocol", THIRD INTERNATIONAL CONFERENCE ON COMMUNICATIONS AND NETWORKING (COMNET), 2012 , IEEE, 29 mars 2012 (2012-03-29), pages 1-8, XP032186090, DOI: 10.1109/COMNET.2012.6217737 ISBN: 978-1-4673-1007-9**
• **NEVAT I ET AL: "Detection of Gaussian constellations in MIMO systems under imperfect CSI", IEEE TRANSACTIONS ON COMMUNICATIONS, IEEE SERVICE CENTER, PISCATAWAY, NJ. USA, vol. 58, no. 4, avril 2010 (2010-04), pages 1151-1160, XP011306161, ISSN: 0090-6778, DOI: 10.1109/TCOMM.2010.04.080657**
• **ASMA MEJRI ET AL: "On the diversity of the Naive Lattice Decoder", 7TH INTERNATIONAL WORKSHOP ON SYSTEMS, SIGNAL PROCESSING AND THEIR APPLICATIONS (WOSSPA), 2011 , IEEE, 9 mai 2011 (2011-05-09), pages 379-382, XP031951179, DOI: 10.1109/WOSSPA.2011.5931516 ISBN: 978-1-4577-0689-9**

EP 3 039 805 B1

**Description**

**DOMAINE TECHNIQUE**

La présente invention concerne le domaine des télécommunications numériques et plus particulièrement du décodage d'une source d'information dont les symboles ne suivent pas une distribution uniforme. Elle s'applique notamment au décodage dans des réseaux utilisant une technique de codage réseau de couche physique (*Physical Layer Network Coding*).

**ÉTAT DE LA TECHNIQUE ANTÉRIEURE**

Les communications numériques s'appuient en général sur un modèle de canal discret entre un émetteur capable de transmettre des messages constitués de symboles et un récepteur capable de restituer le message à partir du signal reçu.

Un canal discret peut être considéré comme un système stochastique acceptant en entrée des symboles $x_i$ appartenant à un alphabet $A_X$ et fournissant en sortie des symboles $y_i$ appartenant à un alphabet $A_Y$, les entrées et sorties du canal étant liées par un modèle probabiliste défini par les probabilités :

$$P\left(Y_1 = y_1, ..., Y_m = y_m \middle| X_1 = x_1, ..., X_n = x_n\right) \qquad (1)$$

Le canal est en pratique bruyant autrement dit les symboles en sortie du canal sont affectés par un bruit que l'on suppose généralement blanc et gaussien (BBAG). On note $R_i = Y_i + Z_i$, $i = 1, ..., m$, les échantillons de signal reçu où les $Z_i$ sont des échantillons de bruit.

Le récepteur recherche la séquence de symboles $x_1, ..., x_n$ la plus probable compte tenu du signal reçu, autrement dit recherche la séquence de symboles d'entrée qui maximise la probabilité conditionnelle :

$$P\left(X_1 = x_1, ..., X_n = x_n \middle| R_1 = r_1, .., R_m = r_m\right) \qquad (2)$$

que l'on notera plus simplement $P(X|R)$ où $X$ est le vecteur des symboles d'entrée que l'on cherche à estimer et $R$ le vecteur des échantillons du signal reçu.

En d'autres termes, on recherche le vecteur $\hat{X}$ maximisant la probabilité :

$$P\left(X \middle| R\right) = P\left(R \middle| X\right) P\left(X\right) / P(R) \qquad (3)$$

Le terme $P(R)$ étant indépendant de $X$, il suffit de rechercher le vecteur $\hat{X}$ maximisant la probabilité :

$$P\left(R \middle| X\right) P\left(X\right) \qquad (4)$$

On distingue à ce stade deux types de méthodes de décodage. Le premier type de décodage utilise un critère dit à maximum de vraisemblance ou ML (*Maximum Likelihood*), reposant sur l'hypothèse que les symboles de l'alphabet $A_X$ sont équiprobables. Il suffit alors de maximiser $P(R|X)$, c'est-à-dire, lorsque le canal est sans mémoire :

$$\hat{X}_{ML} = \arg\max_X P\left(R \middle| X\right) = \prod_{i=1}^{m} \arg\max_{x_i} P\left(R_i \middle| x_i\right) \qquad (5)$$

Cette méthode de décodage est optimale lorsque les symboles d'entrée sont effectivement équiprobables, c'est-à-dire lorsque l'alphabet $A_X$ présente une distribution de probabilité uniforme.

Un second type de décodage, dit de *Maximum A Posteriori* ou MAP, ne fait pas cette hypothèse simplificatrice. Il nécessite par conséquent de pondérer les probabilités conditionnelles par les probabilités des symboles d'entrée selon l'expression (5). Lorsque le canal est sans mémoire, cette expression devient :

$$\hat{X}_{MAP} = \arg\max_{X} P(R|X) = \arg\max_{x_i} \prod_{i=1}^{m} P(R_i|x_i)P(x_i) \qquad (6)$$

Bien qu'un grand nombre de sources d'information présentent une distribution de probabilité non uniforme des symboles de leur alphabet (ci-après désignées comme sources d'information non-uniformes), le décodage ML est généralement préféré en raison de sa plus grande simplicité, malgré son caractère sous-optimal.

Parmi les sources d'information non-uniformes, on peut citer la plupart des sources d'information multimédia (texte, parole, audio, vidéo) en raison de la forte corrélation qu'elles présentent entre symboles (bits) successifs. Si la compression d'information permet de réduire fortement cette redondance, elle ne l'élimine pas complètement.

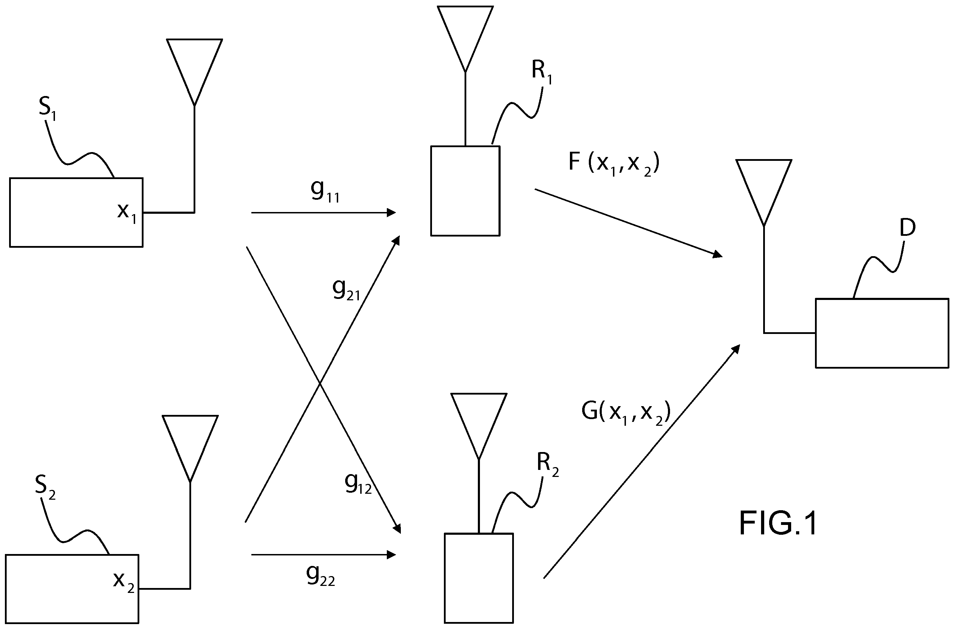

La non-uniformité de la distribution de probabilité des symboles à décoder peut ne pas résulter de la source d'information mais de la stratégie de communication utilisée. Ainsi dans les réseaux coopératifs utilisant une technique de codage réseau au niveau de la couche physique (*Physical Layer Network Coding*), des terminaux relais reçoivent des combinaisons de signaux de différents terminaux sources. On trouvera une introduction au codage réseau au niveau de la couche physique dans l'article de S. Zhang et al. Intitulé « Physical Layer Network Coding », publié dans Proc. Of ACM Mobicom, 2006, pp. 358-365. Même si la distribution de probabilité des symboles émis par les terminaux sources est uniforme, la combinaison de ces symboles au niveau du terminal relais ne l'est pas. Ainsi dans l'exemple simple illustré en Fig. 1 où deux terminaux sources $S_1,S_2$ transmettent des symboles $x_1$ et $x_2$ à deux terminaux relais $R_1,R_2$, qui les décodent avant de les recoder éventuellement et les retransmettre à un terminal de destination D, si l'on suppose les gains des canaux unitaires entre sources et relais, les relais recevront tous deux le symbole somme $x_1 + x_2$. Si les terminaux sources utilisent un alphabet BPSK à probabilité uniforme, les probabilités des symboles sommes -2,0,2 seront respectivement de 1/4, 1/2 et 1/4. De manière plus générale, si un terminal relais reçoit des symboles BPSK d'une pluralité de $K$ terminaux sources, le symbole somme reçu du relais suivra une distribution de probabilité binomiale $B(K,2)$. La même conclusion vaut pour des symboles QPSK, la distribution de probabilité étant alors binomiale sur chacun des axes en phase et en quadrature.

Dans les deux cas précités, non-uniformité originelle de la source d'information, non-uniformité induite par le réseau, il s'agit pour le récepteur de décoder des symboles d'information appartenant à un alphabet présentant une distribution de probabilité non-uniforme.

Comme indiqué plus haut, la méthode de décodage optimale est un décodage MAP mais celui-ci est difficilement réalisable en pratique en raison de sa grande complexité. En particulier, dans le contexte du codage réseau, il faut faire une recherche exhaustive sur toutes les combinaisons possibles de symboles des différents terminaux sources. Par ailleurs, le décodage ML est sous-optimal en termes de taux d'erreur. D'autre part, les méthodes de décodage ML existantes dans un système de télécommunication utilisant un codage réseau sont également très complexes.

L'article de A. Mejri et al. intitulé « Lattice decoding for the compute-and-forward protocol » publié dans IEEE Proc. of COMNET, 29 mars 2012, pages 1-8, décrit une méthode de décodage par réseau de points de symboles transmis par une pluralité de sources, relayés à destination par un noeud relais selon un protocole C&F.

L'article de Nevat et al. intitulé « Detection of gaussian constellations in MUMO systems under imperfect CSI » publié dans IEEE Trans. on Com., vol. 58, N° 4, avril 2010, pp. 1151-1160 décrit un détecteur MAP dans un système MIMO, les symboles reçus ayant une distribution d'amplitude quasi-gaussienne par la suite d'une mise en forme à la transmission.

Le but de la présente invention est par conséquent de proposer une méthode de décodage de symboles d'information appartenant à un alphabet présentant une distribution de probabilité non-uniforme, qui soit sensiblement plus simple que le décodage MAP par recherche exhaustive et qui présente un taux d'erreur inférieur à celui obtenu au moyen d'un décodage conventionnel par maximum de vraisemblance (ML).

## EXPOSÉ DE L'INVENTION

La présente invention est définie par une méthode de décodage MAP d'un signal reçu à travers un canal bruité, ledit signal étant constitué de symboles appartenant à un alphabet prédéterminé, affectés par un bruit additif blanc gaussien, la distribution de probabilité des symboles au sein de cet alphabet étant non-uniforme, les symboles étant représentés par des points d'un réseau de points $\Lambda = \left\{ \mathbf{x} \,\middle|\, \mathbf{x} = \mathbf{M}\mathbf{a}, \ a \in \mathbb{Z}^N \right\}$ généré par une matrice **M** de taille $N \times N$, dans laquelle :

- on détermine un vecteur **y** de taille $N$ représentatif du signal reçu ;

- on construit un vecteur augmenté $\mathbf{y}_{aug} = \begin{bmatrix} \mathbf{y} \\ \mathbf{0}_N \end{bmatrix}$ où $\mathbf{0}_N$ est un vecteur nul de taille $N$ ;

- on forme un réseau augmenté $\boldsymbol{\Lambda}_{aug} = \left\{ \mathbf{x} \,\middle|\, \mathbf{x} = \mathbf{M}_{aug}\mathbf{a},\ a \in \mathbb{Z}^N \right\}$ de matrice génératrice $\mathbf{M}_{aug} = \begin{bmatrix} \mathbf{M} \\ \beta\mathbf{M} \end{bmatrix}$ où $\beta = \dfrac{\sigma^2}{\sigma_V^2}$ est le rapport entre la variance du bruit et celle d'une distribution de probabilité gaussienne modélisant la distribution de probabilité non uniforme des symboles de l'alphabet ;

- on recherche parmi les points du réseau augmenté celui qui est le plus proche voisin du vecteur représentatif du signal reçu, $\hat{\mathbf{a}}$ ;

- on estime le symbole reçu à partir de la matrice génératrice $\mathbf{M}$ et du plus proche voisin, $\hat{\mathbf{v}}_{MAP*} = \mathbf{M}\hat{\mathbf{a}}$.

Avantageusement, la recherche du plus proche voisin est limitée à un sous-ensemble fini $\Omega_a$ du réseau de points traduisant une contrainte sur l'énergie du signal.

Selon un premier mode de réalisation de l'invention, le canal bruité est un canal composé d'une pluralité $K$ de canaux élémentaires entre des terminaux source et un terminal relais d'un réseau et les symboles sont chacun constitués d'une combinaison de symboles élémentaires respectivement transmis par les terminaux source audit terminal relais, lesdits symboles élémentaires appartenant chacun à un alphabet élémentaire d'un terminal source.

Dans un exemple d'application, les alphabets élémentaires des terminaux source sont identiques et la variance $\sigma_V^2$ de la distribution de probabilité gaussienne modélisant la distribution de probabilité non uniforme des symboles de l'alphabet est obtenue par $\sigma_V^2 = K\sigma_X^2$ où $\sigma_X^2$ est la variance de la distribution de probabilité des symboles élémentaires au sein d'un alphabet élémentaire.

La variance $\sigma_X^2$ est obtenue dans ce cas par $\sigma_X^2 = NP_{\max}$ où $P_{\max}$ est la puissance d'émission maximale d'un terminal source.

Avantageusement, la recherche du plus proche voisin est effectuée au moyen d'un décodeur par sphère et le décodage par sphère utilise une énumération des points selon l'algorithme de Pohst.

Alternativement, la recherche du plus proche voisin pourra être effectuée au moyen d'un décodage par décodeur à pile et à borne sphérique.

## BRÈVE DESCRIPTION DES DESSINS

D'autres caractéristiques et avantages de l'invention apparaîtront à la lecture de modes de réalisation préférentiels de l'invention, en référence aux figures jointes parmi lesquelles :

La Fig. 1 représente un exemple simplifié de réseau coopératif utilisant un codage réseau au niveau de la couche physique ;
La Fig. 2 représente une courbe de taux d'erreur en fonction du rapport signal à bruit pour un exemple d'application de la méthode de décodage MAP par réseau augmenté selon un mode de réalisation de la présente invention ;
La Fig. 3 représente un ordinogramme de la méthode de décodage MAP par réseau augmenté selon un mode de réalisation de la présente invention.

## EXPOSÉ DÉTAILLÉ DE MODES DE RÉALISATION PARTICULIERS

Nous considérerons dans la suite un alphabet de symboles d'information présentant une distribution de probabilité non-uniforme. Autrement, dit les symboles de cet alphabet ne sont pas équiprobables.

Cet alphabet peut être par exemple celui utilisé par une source d'information non-uniforme ou bien celui résultant d'une combinaison au niveau d'un relais dans un réseau coopératif mettant en oeuvre un codage réseau au niveau de la couche physique.

Dans un but d'illustration et sans préjudice de généralisation, nous présenterons la méthode de décodage selon l'invention dans le cadre d'un réseau coopératif. Nous supposerons pour cela que $K$ terminaux sources $S_1,...,S_K$ transmettent respectivement $K$ symboles $\mathbf{x}_1,...,\mathbf{x}_K$ et qu'un terminal relais reçoit un signal correspondant à une combinaison de ces symboles, soit :

$$\mathbf{y} = \sum_{k=1}^{K} g_k \mathbf{x}_k + \mathbf{z} \qquad (7)$$

où $g_k$, $k = 1,...,K$ sont les gains respectifs des canaux entre les terminaux sources et le terminal relais. Sans perte de généralité, nous supposerons que ces gains sont unitaires.

Les symboles $\mathbf{x}_k$ sont des éléments d'un alphabet fini $A_X = \Lambda \cap \Omega$, dit alphabet élémentaire, où $\Lambda$ est un réseau de points de dimension $N$, et $\Omega$ est un convexe de $\mathbb{R}^N$, contenant l'origine et définissant la contrainte de puissance d'émission d'un terminal source (supposée identique pour tous les terminaux).

Par exemple, si les symboles $\mathbf{x}_k$ sont des éléments d'un alphabet QAM, le réseau sera de dimension 2. On rappelle qu'un réseau de points de dimension $N$ est défini de manière générale par une matrice $\mathbf{M}$ de taille $N \times N$, où les vecteurs colonne de la matrice sont appelés les vecteurs générateurs du réseau, un point $\mathbf{x}$ du réseau étant défini sous forme vectorielle par $\mathbf{x} = \mathbf{Ma}$ où $\mathbf{a} \in \mathbb{Z}^N$ est un vecteur de dimension $N$ dont les éléments sont des entiers relatifs. Il est toutefois entendu que pour un alphabet QAM l'origine du réseau n'est pas prise en considération ($\mathbf{a} \neq \mathbf{0}_N$). On comprendra que l'on peut toujours considérer les gains $g_k$ unitaires sous réserve de modification de la matrice $\mathbf{M}$.

Le convexe $\Omega$ est typiquement une sphère de $\mathbb{R}^N$ centrée sur l'origine, le rayon de la sphère étant donné par la puissance maximale d'émission du terminal source. Ainsi, si $P_{\max}$ est la puissance maximale d'émission d'un terminal source, le convexe $\Omega$ peut être défini par les points $\mathbf{x}$, tels que :

$$\frac{1}{N} E \left\{ \|\mathbf{x}\|^2 \right\} \leq P_{\max} \qquad (8)$$

où $E\{.\}$ est la valeur moyenne.

Le vecteur $\mathbf{z}$ figurant dans l'expression (7) est un vecteur de bruit de dimension $N$ dont les composantes sont des variables aléatoires gaussiennes de moyenne nulle et de variance $\sigma^2$.

Le terminal relais est équipé d'un décodeur pour décoder la somme $\mathbf{v} = \sum_{k=1}^{K} \mathbf{x}_k$. Après recodage éventuel, celui-ci le transmet au terminal de destination.

Le symbole somme $\mathbf{v} = \sum_{k=1}^{K} \mathbf{x}_k$ appartient à un alphabet $A_V$ résultant de la superposition des alphabets élémentaires $A_X$. Etant donné que le réseau $\Lambda$ est stable par addition ($\Lambda$ muni de l'addition possède une structure de groupe), le symbole somme $\mathbf{v}$ appartient encore au réseau $\Lambda$. Il en résulte que le réseau de points $\Lambda_V$ définissant l'alphabet $A_V$ est un sous-ensemble de $\Lambda$ ($\Lambda_V \subset \Lambda$). L'alphabet $A_V$ des symboles somme est tel que $A_V = \Lambda_V \cap \Omega_V$ où $\Omega_V$ est un convexe de $\mathbb{R}^N$ traduisant la contrainte de puissance d'émission des $K$ terminaux sources.

Un décodage MAP au niveau du relais conduirait à rechercher le vecteur somme $\hat{\mathbf{v}}_{MAP}$ tel que :

$$\hat{\mathbf{v}}_{MAP} = \arg\max_{\mathbf{v} \in \Lambda_V} \left( P(\mathbf{v}|\mathbf{y}) \right) = \arg\max_{\mathbf{v} \in \Lambda_V} \left( P(\mathbf{v}) P(\mathbf{y}|\mathbf{v}) \right) \qquad (9)$$

soit encore :

$$\hat{\mathbf{v}}_{MAP} = \arg\min_{\mathbf{v} \in \Lambda_V} \left( -\ln \left( P(\mathbf{v}) \right) + \frac{\|\mathbf{y} - \mathbf{v}\|^2}{2\sigma^2} \right) \qquad (10)$$

$$P\left(\mathbf{y}\,\middle|\,\mathbf{v}\right) = \exp\left(-\frac{\left\|\mathbf{y} - \mathbf{v}\right\|^2}{2\sigma^2}\right).$$

en tenant compte du fait que

L'idée à la base de l'invention est de modéliser le symbole somme **v** par une variable aléatoire gaussienne de moyenne nulle et de variance $\sigma_V^2 = K\sigma_X^2 = KNP_{\max}$. Cette approximation se justifie par l'application du théorème central limite aux variables aléatoires $\mathbf{x}_k$.

Sur la base de cette approximation, la loi de distribution de probabilité du symbole somme est donnée par :

$$P\left(\mathbf{v}\right) = \frac{1}{\left(\sigma_V\sqrt{2\pi}\right)^N}\exp\left(-\frac{\left\|\mathbf{v}\right\|^2}{2\sigma_V^2}\right) \tag{11}$$

En remplaçant cette estimation de $P(\mathbf{v})$ dans l'expression (10), on obtient un nouveau critère de décodage :

$$\hat{\mathbf{v}}_{MAP^*} = \arg\min_{\mathbf{v}\in\Lambda_V}\left(N\ln\left(\sigma_V\sqrt{2\pi}\right) + \frac{1}{2\sigma_V^2}\left\|\mathbf{v}\right\|^2 + \frac{1}{2\sigma^2}\left\|\mathbf{y} - \mathbf{v}\right\|^2\right) \tag{12}$$

Etant donné que le premier terme ne dépend pas de **v**, le décodage revient à déterminer :

$$\hat{\mathbf{v}}_{MAP^*} = \arg\min_{\mathbf{v}\in\Lambda_V}\left(\left\|\mathbf{y} - \mathbf{v}\right\|^2 + \frac{\sigma^2}{\sigma_V^2}\left\|\mathbf{v}\right\|^2\right) \tag{13}$$

On introduit un vecteur, $\mathbf{y}_{aug}$, dit vecteur augmenté, de taille $2N$, résultant de la concaténation verticale du vecteur **y** et d'un vecteur nul de taille $N$, soit $\mathbf{y}_{aug} = \begin{bmatrix} \mathbf{y} \\ \mathbf{0}_N \end{bmatrix}$ et une matrice de rang plein $\mathbf{B} = \begin{bmatrix} \mathbf{I}_N \\ \beta\mathbf{I}_N \end{bmatrix}$ où $\mathbf{I}_N$ est la matrice identité de taille $N\times N$ et $\beta$ est un coefficient traduisant le rapport entre la variance de bruit et la variance du symbole somme à décoder, soit $\beta = \dfrac{\sigma^2}{\sigma_V^2}$.

Le critère de décodage (13) peut alors s'exprimer comme :

$$\hat{\mathbf{v}}_{MAP^*} = \arg\min_{\substack{\mathbf{v}=\mathbf{Ma} \\ \mathbf{a}\in\Omega_a}}\left(\left\|\mathbf{y}_{aug} - \mathbf{BMa}\right\|^2\right) \tag{14}$$

où l'on a traduit la condition sur la limite de puissance de transmission en contraignant le vecteur **a** à appartenir à un sous-ensemble de $\mathbb{Z}^N$ tel que la contrainte de puissance d'émission soit vérifiée, c'est-à-dire $\Omega_a = \left\{a\in\mathbb{Z}^N \;\middle|\; \dfrac{1}{N}E\left\{\left\|\mathbf{Ma}\right\|^2\right\} \le P_{\max}\right\}$.

Si l'on définit la matrice augmentée $\mathbf{M}_{aug}$ de taille $2N\times N$ par $\mathbf{M}_{aug} = \mathbf{BM} = \begin{bmatrix} \mathbf{M} \\ \beta\mathbf{M} \end{bmatrix}$, le critère de décodage s'exprime enfin sous la forme :

$$\hat{\mathbf{v}}_{MAP*} = \arg\min_{\substack{\mathbf{v}=\mathbf{Ma}\\ \mathbf{a}\in\Omega_a}} \left( \left\| \mathbf{y}_{aug} - \mathbf{M}_{aug}\mathbf{a} \right\|^2 \right) \tag{15}$$

autrement dit, cela revient à rechercher le point d'un réseau augmenté $\Lambda_{aug}$, engendré par la matrice $\mathbf{M}_{aug}$, qui est le plus proche du point $\mathbf{y}_{aug}$, représentant le signal reçu. On comprend par conséquent que l'on se ramène ainsi à un décodage de type ML classique dans un espace augmenté, de dimension $2N$, le réseau de points $\Lambda_{aug}$ ainsi que le point représentatif du signal reçu $\mathbf{y}_{aug}$ étant tous deux de dimension $2N$.

La recherche du plus proche voisin de $\mathbf{y}_{aug}$ dans le réseau augmenté $\Lambda_{aug}$ peut être réalisée de manière classique au moins d'un décodage par sphère. On rappelle qu'un décodage par sphère permet de limiter la recherche du plus proche voisin aux points du réseau appartenant à une boule de bruit centrée sur le point représentant le signal reçu. On trouvera une description du décodeur par sphère dans l'article d'E. Viterbo et al. intitulé « A universal lattice code decoder for fading channels » publié dans IEEE Transactions on Information Theory, vol. 45, pages 1639-1642, Juillet 1999. On pourra également utiliser un décodeur à pile et à borne sphérique (*SB-Stack decoder*) tel que décrit dans l'article de G. Rekaya Ben-Othman intitulé « The spherical bound stock decoder » publié dans Proc. of IEEE International Conférence on Wireless & Mobile Computing, Networking & Communication, pp. 322-327.

La recherche du plus proche voisin par le décodeur par sphère pourra notamment utiliser une énumération de Pohst connue en soi.

Le décodeur par sphère part d'une sphère de bruit de rayon $C$ centrée sur le point $\mathbf{y}_{aug}$ représentatif du signal reçu. Les points $\mathbf{a}$ du réseau $\Lambda_{aug}$ appartenant à cette sphère vérifient :

$$\left\| \mathbf{y}_{aug} - \mathbf{M}_{aug}\mathbf{a} \right\|^2 \leq C^2 \tag{16}$$

La recherche du plus proche voisin doit également prendre en compte le fait que le point $\mathbf{a}$ doit vérifier la contrainte de puissance, c'est-à-dire $\mathbf{a} \in \Omega_a$.

Dans une étape préliminaire, la matrice augmentée $\mathbf{M}_{aug}$ fait l'objet d'une décomposition QR, c'est-à-dire $\mathbf{M}_{aug}=\mathbf{QR}$ où $\mathbf{Q}$ est une matrice de taille $2N\times N$ dont les vecteurs colonnes sont orthogonaux et $\mathbf{R}$ est une matrice triangulaire supérieure de taille $N\times N$. Si l'on note $\boldsymbol{\rho} = \mathbf{M}_{aug}^{-1}\mathbf{y}_{aug}$ (solution *par Zero Forcing*) et $\xi = \boldsymbol{\rho}\text{-}\mathbf{a}$, l'inégalité (16) peut se réécrire :

$$\left\| \mathbf{R}\xi \right\| \leq C^2 \tag{17}$$

soit encore :

$$\sum_{i=1}^{N} p_{ii} \left( \xi_i + \sum_{j=i+1}^{N} p_{ij}\xi_j \right)^2 \leq C^2 \tag{18}$$

où $p_{ii} = r_{ii}^2$, $i = 1,...,N$ et $p_{ij} = \dfrac{r_{ij}}{r_{ii}}$, $j = i + 1,...,N$.

La recherche commence par la N$^{\text{ème}}$ composante de $\mathbf{a}$ :

$$-\frac{C}{\sqrt{p_{NN}}} \leq \xi_n \leq \frac{C}{\sqrt{p_{NN}}} \tag{19}$$

soit, compte tenu du fait que $a_n \in \mathbb{Z}$ :

$$\left\lceil \rho_N - \frac{C}{\sqrt{p_{NN}}} \right\rceil \le a_n \le \left\lfloor \rho_N + \frac{C}{\sqrt{p_{NN}}} \right\rfloor \tag{20}$$

De manière similaire, la recherche pour les autres composantes est limitée aux intervalles :

$$\left\lceil -\sqrt{\frac{T_i}{p_{ii}}} + S_i \right\rceil \le a_i \le \left\lfloor \sqrt{\frac{T_i}{p_{ii}}} + S_i \right\rfloor \tag{21}$$

où $\quad S_i = \rho_i + \sum_{j=1}^{N} p_{ij}\xi_j \quad$ et $T_i = T_{i-1} - p_{ii}(S_{ii} - a_i)$ avec $T_N = C^2$. La recherche est effectuée de la dernière composante à la première, le choix d'une composante d'indice donné de **a** réduisant l'intervalle de recherche pour la composante d'indice inférieur.

Les intervalles de recherche (20) et (21) peuvent s'exprimer à l'aide de la notation simplifiée :

$$b_i^- \le a_i \le b_i^+ , \ i = 1,...,N \tag{22}$$

$$b_i^- = \left\lceil -\sqrt{\frac{T_i}{p_{ii}}} + S_i \right\rceil \ \text{et} \ b_i^+ = \left\lfloor \sqrt{\frac{T_i}{p_{ii}}} + S_i \right\rfloor$$

Il faut en outre restreindre les intervalles de recherche pour tenir compte de la contrainte de puissance d'émission maximale, $\mathbf{a} \in \Omega_a$. Celle-ci impose pour chaque composante $a_i$ de **a** de rester entre deux bornes :

$$\omega_i^- \le a_i \le \omega_i^+ , \ i = 1,...,N \tag{23}$$

En définitive, l'intervalle de recherche $I_i$ pour chaque composante $a_i$ est donc réduit à :

$$\sup\left(\omega_i^-, b_i^-\right) \le a_i \le \inf\left(\omega_i^+, b_i^+\right) \tag{24}$$

Le décodage procède alors comme suit : on choisit d'abord une composante $a_N$ dans l'intervalle $I_N = \left[ \sup\left(\omega_N^-, b_N^-\right), \inf\left(\omega_N^+, b_N^+\right) \right]$, puis on recherche un candidat pour la composante $a_{N-1}$ dans l'intervalle $I_{N-1} = \left[ \sup\left(\omega_{N-1}^-, b_{N-1}^-\right), \inf\left(\omega_{N-1}^+, b_{N-1}^+\right) \right]$ dont les bornes ont été calculées à partir de $a_N$. Si aucune valeur $a_{N-1}$ n'existe dans cet intervalle, on retourne au niveau $N$ pour sélectionner un autre candidat pour la composante $a_N$. On procède ainsi de proche en proche jusqu'à ce qu'on atteigne le niveau 1. Une fois trouvé un vecteur **â** dont les composantes satisfont toutes les conditions (24), le rayon de la sphère est mis à jour et le processus de recherche est itéré en balayant l'ensemble des intervalles $I_i$, jusqu'à ce que le vecteur **â** le plus proche de $\mathbf{y}_{aug}$ soit trouvé. Le symbole $\hat{\mathbf{v}}_{MAP*}$ est donné par $\hat{\mathbf{v}}_{MAP*} = \mathbf{M}\hat{\mathbf{a}}$.

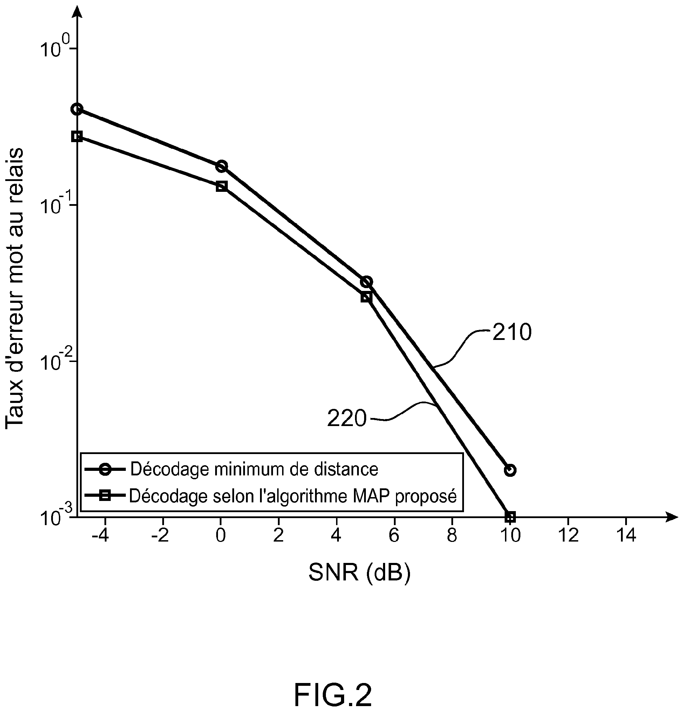

La Fig. 2 représente le taux d'erreur de décodage par symbole au niveau du relais, en fonction du rapport signal sur bruit.

Dans le cas illustré, on a supposé $N = 4$ , $K = 2$ et une puissance d'émission maximale $P_{max} = 1$.

On a indiqué en 210 la courbe correspondant à la méthode de décodage à maximum de vraisemblance (ML) classique et en 220 celle correspondant à la méthode de décodage MAP par réseau augmenté selon la présente invention. Cette figure confirme que la méthode de décodage par réseau augmenté permet d'atteindre un plus faible taux d'erreur symbole pour un rapport signal sur bruit donné ou bien de gagner en termes de rapport signal sur bruit pour un même taux d'erreur symbole cible. On a pu noter que le gain était d'autant plus important que la dimension $N$ du réseau était élevée.

L'homme du métier comprendra que d'autres algorithmes de recherche de plus proche voisin au sein d'un réseau de points pourront être mis en oeuvre en lieu et place du décodeur par sphère, notamment le décodage de Schnorr-Euchner, sans sortir du cadre de la présente invention.

Nous présenterons ci-après la méthode de décodage MAP par réseau augmenté dans un cadre général.

La méthode de décodage vise à décoder un signal reçu à travers un canal bruité, ledit signal étant constitué de symboles d'information appartenant à un alphabet prédéterminé. La distribution de probabilité des symboles d'information au sein de cet alphabet est non-uniforme, autrement dit certains symboles d'information sont plus fréquents que d'autres. Le bruit affectant le canal est supposé blanc et gaussien.

On suppose que les symboles de l'alphabet peuvent être représentés par des points d'un réseau $\Lambda$ de dimension $N$ défini par la relation $\left\{ \mathbf{x} \,\middle|\, \mathbf{x} = \mathbf{Ma}, \ a \in \mathbb{Z}^N \right\}$ où $\mathbf{M}$ est la matrice génératrice du réseau. Cette condition est notamment vérifiée dès lors que les symboles appartiennent à une constellation de modulation de type QAM. L'alphabet est une sous-partie finie de $\Lambda$, définie comme intersection entre ledit réseau et d'un convexe $\Omega$ de $\mathbb{R}^N$ Dans le cas d'un alphabet QAM, on notera que l'origine du réseau est toutefois exclue. Du fait de la non-uniformité de la distribution de probabilité des symboles de l'alphabet, les différents points du réseau sont pondérés par des probabilités différentes.

Selon l'invention, la distribution de probabilité des symboles de l'alphabet est modélisée par une distribution gaussienne de variance $\sigma_V^2$.

Le signal à décoder s'exprime sous la forme de $\mathbf{y} = \mathbf{x} + \mathbf{z}$, où $\mathbf{x}$ est un point de $\Lambda \cap \Omega$ et $\mathbf{z}$ est un vecteur de bruit de dimension $N$ dont les composantes sont des variables aléatoires de variance $\sigma^2$.

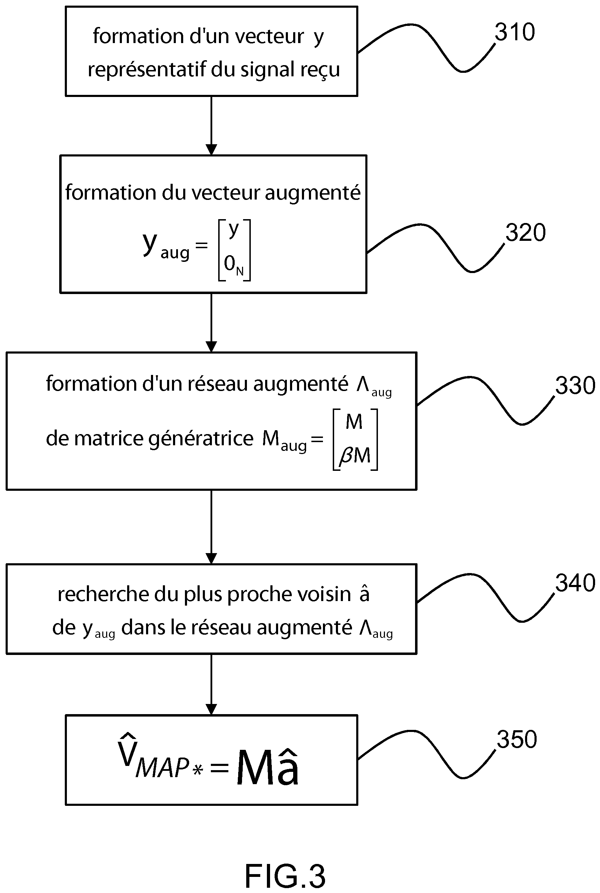

La Fig. 3 représente de manière schématique l'ordinogramme de la méthode de décodage par réseau augmenté selon un mode de réalisation général de l'invention.

A l'étape 310, on forme un vecteur $\mathbf{y}$ représentatif du signal reçu dans un espace de dimension $N$ où $N$ est la dimension du réseau de points $\Lambda$. Ce vecteur peut par exemple être obtenu par démodulation du signal reçu.

A l'étape 320, on construit le vecteur augmenté $$\mathbf{y}_{aug} = \begin{bmatrix} \mathbf{y} \\ \mathbf{0}_N \end{bmatrix}.$$

A l'étape 330, on forme un réseau augmenté $\Lambda_{aug}$ de matrice génératrice $\mathbf{M}_{aug} = \begin{bmatrix} \mathbf{M} \\ \beta\mathbf{M} \end{bmatrix}$ où $\mathbf{M}$ est la matrice génératrice du réseau $\Lambda$ et $\beta = \dfrac{\sigma^2}{\sigma_V^2}$ est le rapport entre la variance du bruit et celle de la distribution de probabilité gaussienne modélisant la distribution de probabilité non uniforme des symboles de l'alphabet.

A l'étape 340, on effectue une recherche du plus proche voisin du vecteur augmenté $\mathbf{y}_{aug}$ dans le réseau augmenté $\Lambda_{aug}$, autrement du vecteur $\hat{\mathbf{a}}$ de $\Omega_a$ minimisant la distance $\|\mathbf{y}_{aug} - \mathbf{M}_{aug}\mathbf{a}\|^2$, où $\Omega_a$ est une partie de $\mathbb{Z}^N$ traduisant une contrainte d'énergie maximale du signal reçu.

A l'étape 350, on estime le symbole reçu au sens du critère MAP par $\hat{\mathbf{v}}_{MAP*} = \mathbf{M}\hat{\mathbf{a}}$.

On comprendra que la recherche du plus proche voisin dans le réseau pourra être effectuée à l'aide d'un décodeur par sphère ou d'un décodeur à pile et à borne sphérique, comme indiqué plus haut. Les différentes variantes connues de décodage par sphère sont ici applicables, en particulier celles mettant en oeuvre une énumération des points selon l'algorithme de Pohst.

L'homme du métier comprendra que le décodage de symboles somme dans le cadre d'un canal d'un réseau coopératif est un cas particulier du décodage de la Fig. 3 dans la mesure où ces symboles somme font partie d'un alphabet obtenu par superposition des alphabets élémentaires des différents terminaux source et que la distribution des symboles somme au sein de cet alphabet et non-uniforme.

Enfin, comme indiqué précédemment, d'autres algorithmes de recherche de plus proche voisin dans un réseau de points, notamment le décodage de Schnorr-Euchner, pourront être mis en oeuvre sans sortir du cadre de la présente invention.

**Revendications**

1. Méthode de décodage MAP d'un signal reçu à travers un canal bruité, ledit signal étant constitué de symboles appartenant à un alphabet prédéterminé, affectés par un bruit additif blanc gaussien, la distribution de probabilité des symboles au sein de cet alphabet étant non-uniforme, les symboles étant représentés par des points d'un réseau de points $\Lambda = \left\{ \mathbf{x} \middle| \mathbf{x} = \mathbf{M}a, \ a \in \mathbb{Z}^N \right\}$ généré par une matrice **M** de taille $N \times N$, dans laquelle

   - on détermine (310) un vecteur **y** de taille *N* représentatif du signal reçu

   **caractérisée en ce que** :

   - on construit (320) un vecteur augmenté $\mathbf{y}_{aug} = \begin{bmatrix} \mathbf{y} \\ \mathbf{0}_N \end{bmatrix}$ où $\mathbf{0}_N$ est un vecteur nul de taille *N* ;

   - on forme (330) un réseau augmenté $\Lambda_{aug} = \left\{ \mathbf{x} \middle| \mathbf{x} = \mathbf{M}_{aug}\mathbf{a}, \ a \in \mathbb{Z}^N \right\}$ de matrice génératrice $\mathbf{M}_{aug} = \begin{bmatrix} \mathbf{M} \\ \beta \mathbf{M} \end{bmatrix}$ où $\beta = \dfrac{\sigma^2}{\sigma_V^2}$ est le rapport entre la variance du bruit et celle d'une distribution de probabilité gaussienne modélisant la distribution de probabilité non uniforme des symboles de l'alphabet ;
   - on recherche (340) parmi les points du réseau augmenté celui qui est le plus proche voisin du vecteur augmenté $y_{aug}$ représentatif du signal reçu, **â** ;
   - on estime (350) le symbole reçu à partir de la matrice génératrice **M** et du plus proche voisin, $\hat{\mathbf{v}}_{MAP^*} = \mathbf{M}\hat{a}$.

2. Méthode de décodage MAP selon la revendication 1, **caractérisée en ce que** la recherche du plus proche voisin est limitée à un sous-ensemble fini $\Omega_a$ du réseau de points traduisant une contrainte sur l'énergie du signal.

3. Méthode de décodage MAP selon la revendication 1 ou 2, **caractérisée en ce que** le canal bruité est un canal composé d'une pluralité *K* de canaux élémentaires entre des terminaux source et un terminal relais d'un réseau et que les symboles sont chacun constitués d'une combinaison de symboles élémentaires respectivement transmis par les terminaux source audit terminal relais, lesdits symboles élémentaires appartenant chacun à un alphabet élémentaire d'un terminal source.

4. Méthode de décodage MAP selon la revendication 3, **caractérisée en ce que** les alphabets élémentaire des terminaux source sont identiques et que la variance $\sigma_V^2$ de la distribution de probabilité gaussienne modélisant la distribution de probabilité non uniforme des symboles de l'alphabet est obtenue par $\sigma_V^2 = K\sigma_X^2$ où $\sigma_X^2$ est la variance de la distribution de probabilité des symboles élémentaires au sein d'un alphabet élémentaire.

5. Méthode de décodage MAP selon la revendication 4, **caractérisée en ce que** la variance $\sigma_X^2$ est obtenue par $\sigma_X^2 = NP_{max}$ où $P_{max}$ est la puissance d'émission maximale d'un terminal source.

6. Méthode de décodage MAP selon l'une des revendications précédentes, **caractérisée en ce que** la recherche du plus proche voisin est effectuée au moyen d'un décodeur par sphère.

7. Méthode de décodage MAP selon la revendication 6, **caractérisée en ce que** le décodage par sphère utilise une énumération des points selon l'algorithme de Pohst.

8. Méthode de décodage MAP selon l'une des revendications 1 à 5, **caractérisée en ce que** la recherche du plus proche voisin est effectuée au moyen d'un décodage par décodeur à pile et à borne sphérique.

**Patentansprüche**

1. MAP-Decodierungsverfahren eines über einen Kanal mit Rauschen empfangenen Signals, wobei das Signal aus Symbolen besteht, welche einem vorbestimmten Alphabet angehören, welche einem gaußschen weißen Rauschen unterliegen, wobei die Wahrscheinlichkeitsstreuung der Symbole innerhalb dieses Alphabets nicht einheitlich ist, wobei die Symbole durch Punkte eines Netzwerks von Punkten $\Lambda = \left\{ \mathbf{x} \middle| \mathbf{x} = \mathbf{Ma}, \ a \in \mathbb{Z}^N \right\}$ dargestellt werden, welches durch eine Matrix $\mathbf{M}$ der Größe $N \times N$ erzeugt wird, bei welchem:

- einen Vektor $\mathbf{y}$ der Größe $N$ bestimmt (310) wird, welcher das empfangene Signal darstellt;

**dadurch gekennzeichnet, dass**:

- einen erweiterten Vektor $\mathbf{y}_{aug} = \begin{bmatrix} \mathbf{y} \\ \mathbf{0}_N \end{bmatrix}$ konstruiert (320) wird, wobei $\mathbf{0}_N$ ein Nullvektor der Größe $N$ ist;

- ein erweitertes Netzwerk $\Lambda_{aug} = \left\{ \mathbf{x} \middle| \mathbf{x} = \mathbf{M}_{aug} \mathbf{a}, \ a \in \mathbb{Z}^N \right\}$ mit Erzeugungsmatrix $\mathbf{M}_{aug} = \begin{bmatrix} \mathbf{M} \\ \beta \mathbf{M} \end{bmatrix}$ gebildet (330)

wird, wobei $\beta = \dfrac{\sigma^2}{\sigma_V^2}$ das Verhältnis zwischen der Rauschvarianz und der Varianz einer gaußschen Wahrscheinlichkeitsstreuung ist, welches die nicht einheitliche Wahrscheinlichkeitsstreuung der Symbole des Alphabetes modelliert;

- unter den Punkten des erweiterten Netzwerks denjenigen Punkt gesucht (340) wird, welcher der nächste Nachbar des erweiterten Vektors $\mathbf{y}_{aug}$ ist, welcher das empfangene Signal, $\hat{\mathbf{a}}$, darstellt;

- das empfangene Symbol anhand der Erzeugungsmatrix $\mathbf{M}$ und des nächsten Nachbarn, $\hat{\mathbf{v}}_{MAP}^* = \mathbf{M}\hat{\mathbf{a}}$, geschätzt (350) wird.

2. MAP-Decodierungsverfahren nach Anspruch 1, **dadurch gekennzeichnet, dass** die Suche nach dem nächsten Nachbarn sich auf eine endliche Untergruppe $\Omega_{\alpha}$, des Punktenetzwerks beschränkt, welche eine Spannung auf die Energie des Signals übersetzt.

3. MAP-Decodierungsverfahren nach Anspruch 1 oder 2, **dadurch gekennzeichnet, dass** der Kanal mit Rauschen ein Kanal ist, der aus einer Vielzahl $K$ von Elementarkanälen zwischen Quellklemmen und einer Relaisklemme eines Netzwerks besteht, und die Symbole jeweils aus einer Kombination von Elementarsymbolen bestehen, welche jeweils durch die Quellklemmen an die Relaisklemme übertragen werden, wobei die Elementarsymbole jeweils einem Elementaralphabet einer Quellklemme angehören.

4. MAP-Decodierungsverfahren nach Anspruch 3, **dadurch gekennzeichnet, dass** die Elementaralphabete der Quellklemmen identisch sind und die Varianz $\sigma_V^2$ der gaußschen Wahrscheinlichkeitsstreuung, welche die nicht einheitliche Wahrscheinlichkeitsstreuung der Symbole des Alphabets modelliert, anhand von $\sigma_V^2 = K \sigma_X^2$ erzielt wird, wobei $\sigma_X^2$ die Varianz der Wahrscheinlichkeitsstreuung der Elementarsymbole innerhalb eines Elementaralphabetes ist.

5. MAP-Decodierungsverfahren nach Anspruch 4, **dadurch gekennzeichnet, dass** die Varianz $\sigma_X^2$ anhand von $\sigma_X^2 = NP_{\max}$ erzielt wird, wobei $P_{\max}$ die maximale Sendeleistung einer Quellklemme ist.

6. MAP-Decodierungsverfahren nach einem der vorhergehenden Ansprüche, **dadurch gekennzeichnet, dass** die Suche nach dem nächsten Nachbarn mit Hilfe eines Kugeldecoders erfolgt.

7. MAP-Decodierungsverfahren nach Anspruch 6, **dadurch gekennzeichnet, dass** die Kugeldecodierung eine Aufzählung der Punkte nach dem Pohst-Algorithmus verwendet.

8. MAP-Decodierungsverfahren nach einem der Ansprüche 1 bis 5, **dadurch gekennzeichnet, dass** die Suche nach dem nächsten Nachbarn mit Hilfe einer Decodierung mittels eines Decoders mit Stapel und mit Kugelklemme erfolgt.

**Claims**

1. A method for MAP decoding of a signal received through a noisy channel, said signal being made up of symbols belonging to a predetermined alphabet that are affected by an additive white Gaussian noise, the probability distribution of the symbols within said alphabet being non-uniform, the symbols being represented by points in a lattice of points $\Lambda = \left\{ \mathbf{x} \middle| \mathbf{x} = \mathbf{Ma}, \ a \in \mathbb{Z}^N \right\}$ generated by a matrix **M** of size $N \times N$, wherein:

   - a vector **y** of size $N$ is determined (310) representing the received signal;

   **characterised in that**:

   - an augmented vector $\mathbf{y}_{aug} = \begin{bmatrix} \mathbf{y} \\ \mathbf{0}_N \end{bmatrix}$ is created (320), where $\mathbf{0}_N$ is a zero vector of size $N$;

   - an augmented lattice $\Lambda_{aug} = \left\{ \mathbf{x} \middle| \mathbf{x} = \mathbf{M}_{aug}\mathbf{a}, \ a \in \mathbb{Z}^N \right\}$ with a generating matrix $\mathbf{M}_{aug} = \begin{bmatrix} \mathbf{M} \\ \beta\mathbf{M} \end{bmatrix}$ is formed (330), where $\beta = \frac{\sigma^2}{\sigma_V^2}$ is the ratio between the variance of the noise and the variance of a Gaussian probability distribution modelling the non-uniform probability distribution of the symbols of the alphabet;
   - the closest neighbour of the augmented vector $y_{aug}$ representing the received signal, **â**, is sought (340) from among the points of the augmented lattice;
   - the received symbol (350) is estimated based on the generating matrix **M** and on the closest neighbour, $\hat{\mathbf{v}}_{MAP^*} = \mathbf{M}\hat{\mathbf{a}}$.

2. The MAP decoding method as claimed in claim 1, **characterised in that** the search for the closest neighbour is limited to a finite sub-set $\Omega_a$ of the lattice expressing a constraint on the signal energy.

3. The MAP decoding method as claimed in claim 1 or 2, **characterised in that** the noisy channel is a channel made up of a plurality K of elementary channels between source terminals and a relay terminal of a lattice and **in that** the symbols are each made up of a combination of elementary symbols respectively transmitted by the source terminals to said relay terminal, said elementary symbols each belonging to an elementary alphabet of a source terminal.

4. The MAP decoding method as claimed in claim 3, **characterised in that** the elementary alphabets of the source terminals are identical and **in that** the variance $\sigma_V^2$ of the Gaussian probability distribution modelling the non-uniform probability distribution of the symbols of the alphabet is obtained by $\sigma_V^2 = K\sigma_X^2$, where $\sigma_X^2$ is the variance of the probability distribution of the elementary symbols within an elementary alphabet.

5. The MAP decoding method as claimed in claim 4, **characterised in that** the variance $\sigma_X^2$ is obtained by $\sigma_X^2 = NP_{max}$, where $P_{max}$ is the maximum transmission power of a source terminal.

6. The MAP decoding method as claimed in any one of the preceding claims, **characterised in that** the search for the closest neighbour is carried out by means of a sphere decoder.

7. The MAP decoding method as claimed in claim 6, **characterised in that** the sphere decoding uses an enumeration of the points according to the Pohst algorithm.

8. The MAP decoding method as claimed in any one of claims 1 to 5, **characterised in that** the search for the closest neighbour is carried out by means of decoding using a spherical bound stack decoder.

F $(x_1, x_2)$

G$(x_1, x_2)$

$g_{11}$

$g_{21}$

$g_{12}$

$g_{22}$

$S_1$

$S_2$

$R_1$

$R_2$

$x_1$

$x_2$

D

FIG.1

FIG.2

formation d'un vecteur y
représentatif du signal reçu     310

formation du vecteur augmenté

$$y_{aug} = \begin{bmatrix} y \\ 0_N \end{bmatrix}$$     320

formation d'un réseau augmenté $\Lambda_{aug}$

de matrice génératrice $M_{aug} = \begin{bmatrix} M \\ \beta M \end{bmatrix}$     330

recherche du plus proche voisin $\hat{a}$
de $y_{aug}$ dans le réseau augmenté $\Lambda_{aug}$     340

$$\hat{v}_{MAP*} = M\hat{a}$$     350

FIG.3

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **S. ZHANG et al.** Physical Layer Network Coding. *Proc. Of ACM Mobicom,* 2006, 358-365
- **A. MEJRI et al.** Lattice decoding for the compute-and-forward protocol. *IEEE Proc. of COMNET,* 29 Mars 2012, 1-8
- **NEVAT et al.** Detection of gaussian constellations in MUMO systems under imperfect CSI. *IEEE Trans. on Com.,* Avril 2010, vol. 58 (4), 1151-1160
- **E. VITERBO et al.** A universal lattice code decoder for fading channels. *IEEE Transactions on Information Theory,* Juillet 1999, vol. 45, 1639-1642
- **G. REKAYA BEN-OTHMAN.** The spherical bound stock decoder. *Proc. of IEEE International Conférence on Wireless & Mobile Computing, Networking & Communication,* 322-327